# EUROPÄISCHE PATENTSCHRIFT

(11) **EP 4 009 201 B1**
(45) Veröffentlichungstag und Bekanntmachung des Hinweises auf die Patenterteilung: **04.03.2026**
(21) Anmeldenummer: 21211306.2
(22) Anmeldetag: 30.11.2021
(51) Int. Cl.: G06F 17/16, G06F 30/3308, G06F 30/343, G05B 17/02, G06F 30/331

(54) **VERFAHREN, COMPUTERSYSTEM UND COMPUTERLESBAREN SPEICHERMEDIUM ZUR SIMULATION EINES ELEKTRISCHEN MOTORS**
METHOD, COMPUTER SYSTEM AND COMPUTER READABLE STORAGE MEDIUM FOR SIMULATING AN ELECTRIC MOTOR
PROCÉDÉ, SYSTÈME INFORMATIQUE ET SUPPORT DE STOCKAGE LISIBLE PAR ORDINATEUR DE SIMULATION D'UN MOTEUR ÉLECTRIQUE

(30) Priorität: 03.12.2020 DE 102020132119
(43) Veröffentlichungstag der Anmeldung: 08.06.2022
(73) Patentinhaber: dSPACE GmbH, 33102 Paderborn (DE)
(72) Erfinder: Aust, Martin, 33102 Paderborn (DE)

(56) Entgegenhaltungen:
- US-A1- 2011 307 233
- US-A1- 2019 339 944
- US-A1- 2020 311 330

## Beschreibung

Die Erfindung betrifft ein computerimplementiertes Verfahren zur Echtzeitsimulation einer elektrischen Schaltung, insbesondere eines elektrischen Motors, ein Computersystem sowie ein computerlesbares Speichermedium. Moderne Produkte wie Steuergeräte werden vielfach mit Hilfe von computergestützten Simulationen eines dynamischen Systems entwickelt. Beispielsweise kann die Strecke eines Reglers simuliert werden, um eine Komponente wie ein Steuergerät vor der Fertigstellung des Gesamtprodukts in einer Hardware-in-the-Loop-Simulation zu testen. Hierfür werden spezielle Echtzeitrechner eingesetzt, die eine Reaktion innerhalb einer vorgegebenen Maximalzeit gewährleisten. Häufig ist die Systemdynamik begrenzt, so dass beispielsweise eine maximale Latenz im Bereich von Millisekunden angemessen ist und ein Echtzeitrechner mit einem üblichen Prozessor eingesetzt werden kann.

Für elektrische Schaltungen, wie einen Elektromotor oder einen Inverter zur Ansteuerung eines Elektromotors, kann die maximal zulässige Latenz für eine Echtzeitsimulation aber im Bereich von Mikrosekunden liegen. In solchen Fällen wird vorzugsweise ein Echtzeitrechner mit einem programmierbaren Logikbaustein, insbesondere einem Field Programmable Gate Array (FPGA) eingesetzt. Hierbei kann es auch vorgesehen sein, dass die Ansteuerung bzw. eine übergeordnete langsamere Regelung durch einen Rechenknoten mit einem Prozessor erfolgt, der Daten mit dem programmierbaren Logikbaustein austauscht. Ein FPGA wird durch das Einlesen eines Bitstroms konfiguriert, welcher direkt die Verschaltung der einzelnen Logikelemente beeinflusst und somit die ausgeführte Schaltung vorgibt. Relevanter Stand der Technik sind die Patentdokumente US2011307233A1, US2011307233A1 und US2020311330A1. Aus der DE 102019107817 A1 ist ein Verfahren zur Simulation eines dynamischen Systems bekannt, das mit einer fest vorgegebenen Konfiguration insbesondere für kleine elektronische Schaltungen Simulationen mit besonders kurzen Latenzen ermöglicht. Da die Eigenschaften von Elektromotoren, wie beispielsweise die Polzahl des Stators stark variieren können, und auch je nach Anwendungsfall verschiedene Diskretisierungsverfahren (bzw. Solver) eingesetzt werden, ist es zweckmäßig, keine feste Konfiguration zu verwenden, sondern den Bitstrom modellbasiert für den konkreten Motor zu erstellen. Nach dem Stand der Technik ist das allerdings mit einer schlechten Ressourcenausnutzung und einer vergleichsweise langen Latenz verbunden.

Vor diesem Hintergrund besteht die Aufgabe der Erfindung darin, ein Verfahren und eine Vorrichtung zur Simulation einer elektrischen Schaltung - insbesondere eines elektrischen Motors - anzugeben, welche den Stand der Technik weiterbilden. Insbesondere wäre eine effiziente Nutzung der FPGA-Ressourcen wünschenswert.

Diese Aufgabe wird durch ein Verfahren zur Echtzeitsimulation einer elektrischen Schaltung mit den Merkmalen von Anspruch 1, ein computerlesbares Speichermedium mit den Merkmalen von Anspruch 13 zur Ausführung des Verfahrens, und ein Computersystem mit den Merkmalen von Anspruch 12 gelöst. Vorteilhafte Ausgestaltungen der Erfindung sind Gegenstand von abhängigen Unteransprüchen.

Erfindungsgemäß wird also ein Verfahren zur Echtzeitsimulation einer elektrischen Schaltung bereitgestellt, insbesondere eines elektrischen Motors, wobei die elektrische Schaltung in einem grafischen Modell umfassend mindestens zwei durch Signale verbundene Blöcke modelliert ist, wobei das grafische Modell mindestens zwei Matrixoperationen umfasst, welche ein mehrdimensionales Ausgangssignal aus mindestens einem mehrdimensionalen Eingangssignal erzeugen. Das Verfahren wird auf einem Rechnersystem aus einem Bedienrechner und einem mit diesem verbundenen Echtzeitrechner ausgeführt, wobei der Bedienrechner eine grafische Modellierungsumgebung ausführt und der Echtzeitrechner mindestens einen programmierbaren Logikbaustein aufweist. Matrixoperationen sind in zwei getrennten Blöcken implementiert, einem Matrix-Routing-Block und einem Matrix-Berechnungs-Block, wobei der Matrix-Routing-Block dazu eingerichtet ist, den Matrix-Berechnungsblock mit dem jeweils mindestens einen Eingangssignal zu versorgen und das berechnete Ausgangssignal zu speichern, wobei der MatrixBerechnungs-Block dazu eingerichtet ist, auf ein aktuell empfangenes Eingangssignal eine Operation anzuwenden, um ein Ausgangssignal zu berechnen. Die erste Matrixoperation und die zweite Matrixoperation umfassen zwei getrennte Matrix-Routing-Blöcke, aber einen gemeinsamen MatrixBerechnungs-Block, wobei der Matrix-Routing-Block der ersten Matrixoperation und der Matrix-Routing-Block der zweiten Matrixoperation abwechselnd dem Matrix-Berechnungs-Block Eingangssignale zuführen und Ausgangssignale empfangen. Zumindest aus einem die Matrixoperationen umfassenden Teil des grafischen Modells ein Bitstrom generiert und auf dem programmierbaren Logikbaustein ausgeführt.

In einer Ausführungsform der Erfindung wird ein Verfahren zur Echtzeitsimulation einer elektrischen Schaltung bereitgestellt, insbesondere eines elektrischen Motors, wobei die Eigenschaften der elektrischen Schaltung in einem grafischen Modell umfassend mindestens zwei durch Signale verbundene Blöcke modelliert sind, wobei das grafische Modell mindestens zwei Matrixoperationen umfasst, welche ein mehrdimensionales Ausgangssignal aus einem oder mehreren mehrdimensionalen Eingangssignalen erzeugt. Das Verfahren wird auf einem Rechnersystem aus einem Bedienrechner und einem mit diesem verbundenen Echtzeitrechner ausgeführt wird, wobei der Bedienrechner eine grafische Modellierungsumgebung ausführt und der Echtzeitrechner mindestens einen programmierbaren Logikbaustein aufweist. Matrixoperationen sind in zwei getrennten Blöcken implementiert, einem Matrix-Routing-Block und einem Matrix-Berechnungs-Block, wobei die erste Matrixoperation und die zweite Matrixoperation zwei getrennte Matrix-Routing-Blöcke, aber einen gemeinsamen Matrix-Berechnungs-Block umfassen, wobei der erste und der zweite Matrix-Routing-Block dazu eingerichtet sind, den Matrix-Berechnungs-block mit dem oder den Eingangssignalen zu versorgen und das berechnete Ausgangssignal zu speichern, wobei der Matrix-Berechnungs-Block dazu eingerichtet ist, in aufeinanderfolgenden Takten verschiedene Eingangssignale zu empfangen und auf diese Operationen anzuwenden, wobei das resultierende Ausgangsignal nicht im Matrix-Berechnungs-Block gespeichert wird, und wobei zumindest aus einem die Matrixoperationen umfassenden Teil des grafischen Modell ein Bitstrom generiert und auf dem programmierbaren Logikbaustein ausgeführt wird.

Vorteilhafterweise ermöglicht das erfindungsgemäße Verfahren eine bessere Ausnutzung der Hardwareressourcen des FPGAs, und eine verringerte bzw. optimierte Latenz der Berechnungen, so dass eine Maximierung der Abtastraten erfolgen kann.

Darüber hinaus ist eine Erhöhung der Berechnungsgenauigkeit möglich: Bevorzugt ist der Datentyp des Eingangssignals und/oder der Datentyp des Ausgangssignals und/oder der Datentyp der Elemente der Matrix ein Fließkomma-Typ, wie insbesondere Double. Das erfindungsgemäße Verfahren ist unabhängig vom Datentyp anwendbar und nicht auf hinsichtlich Genauigkeit und Skalierung problematische Festkommatypen beschränkt.

Es ist zweckmäßig, wenn der Matrix-Berechnungs-Block dazu eingerichtet ist, auf die Elemente mindestens eines Eingangssignals zeilenweise parallel eine Operation anzuwenden. Um einen guten Kompromiss zwischen Ressourcenbedarf und Latenz zu erreichen, kann es vorgesehen sein, die Spalten des Eingangssignals nacheinander zu bearbeiten. Entsprechend kann auch eine spaltenweise parallele Berechnung mit einer zeilenweisen sequentiellen Berechnung erfolgen.

In einer Ausführungsform der Erfindung kann die Anzahl parallel verarbeiteter Elemente in Abhängigkeit von einem Parameter, insbesondere einer empfangenen Vorgabe eines Benutzers oder einer Eigenschaft des programmierbaren Logikbausteins, vor der Generierung des Bitstroms angepasst werden. Beispielsweise kann eine ganze Eingabezeile parallel verarbeitet werden, wenn der Parameter einen Schwellenwert überschreitet; wenn der Parameter den Schwellenwert unterschreitet kann die Zeile in mehrere Blöcke unterteilt werden, wobei nur die Elemente eines Blocks parallel verarbeitet werden. Indem die Anzahl parallel verarbeiteter Werte angepasst wird, kann die auf dem programmierbaren Logikbaustein vorhandene freie Fläche bzw. die vorhandenen Logikelemente bestmöglich genutzt werden.

Bevorzugt ist der Matrix-Berechnungs-Block zur Verarbeitung von quadratischen Matrizen eingerichtet, wobei die Größe der quadratischen Matrix so gewählt ist, dass diese sowohl die Eingangssignale der ersten Matrixoperation als auch die Eingangssignale der zweiten Matrixoperation umfassen kann, insbesondere anhand der jeweils größten Dimension eines Eingangssignals gewählt wird, und wobei die Berechnung der quadratischen Matrix gestoppt wird, sobald alle Elemente des Ausgangssignals der aktuell aktiven Matrixoperation berechnet wurden. Dies ermöglicht eine hohe Parallelisierung und somit eine geringe Latenz, ohne einen übermäßigen Verbrauch an freier Fläche auf dem programmierbaren Logikbaustein.

Vorzugsweise speichert der Matrix-Berechnungs-Block das aus der Anwendung einer Operation auf ein Eingangssignal resultierende Ausgangsignal nicht zwischen. Dadurch wird ein übermäßiger Verbrauch an Speicherressourcen im programmierbaren Logikbaustein vermieden.

Bevorzugt empfangen der Matrix-Routing-Block der ersten Matrixoperation und der Matrix-Routing-Block der zweiten Matrixoperation ein Trigger-Signal und geben es weiter, um den aktiven Matrix-Routing-Block zu bestimmen, wohingegen der Matrix-Berechnungs-Block immer aktiv ist. Derjenige Matrix-Routing-Block, der ein Trigger-Signal empfängt, ist aktiv und sendet seine Eingangssignale an den Matrixberechnungs-Block, der daraufhin die gewünschte Matrixberechnung durchführt. Nach Empfang des Ergebnisses gibt der aktuell aktive Matrix-Routing-Block zweckmäßigerweise das Trigger-Signal weiter, so dass der nächste Matrix-Routing-Block aktiv werden kann. Besonders bevorzugt führt ein Matrix-Routing-Block also auf das Empfangen des Trigger-Signals dem verbundenen Matrix-Berechnungs-Block das mindestens eine Eingangssignal und gibt das Trigger-Signal auf das Abspeichern des resultierenden Ausgangssignals weiter.

Vorzugsweise können mehr als zwei Matrix-Routing-Blöcke mit einem MatrixBerechnungs-Block verbunden werden, und der Matrix-Berechnungs-Block ist dazu eingerichtet, fortlaufend die Matrixoperationen aller verbundenen Matrix-Routing-Blöcke auszuführen, so dass in jedem Zeitschritt der Simulation alle zu einem verbundenen Matrix-Routing-Block gehörenden Matrixoperationen einmal durchgeführt werden. Es kann auch vorgesehen sein, einen Scheduler einzusetzen, der anhand einer von außen vorgegebener Reihenfolge bzw. einer übergeordneten Regelung die Abarbeitung der Matrixoperationen steuert.

Bevorzugt umfasst das grafische Modell mehr als einen Matrix-Berechnungs-Block, wobei mindestens zwei erste Matrix-Routing-Blöcke mit dem ersten Matrix-Berechnungs-Block verbunden sind und mindestens zwei zweite Matrix-Routing-Blöcke mit dem zweiten Matrix-Berechnungs-Block verbunden sind. Insbesondere führt der erste Matrix-Berechnungs-Block in jedem Zeitschritt nacheinander die Berechnungen der ersten Matrix-Routing-Blöcke aus, während der zweite Matrix-Berechnungs-Block in jedem Zeitschritt nacheinander die Berechnungen der zweite Matrix-Routing-Blöcke aus. Alternativ kann auch die Verwendung je eines Schedulers vorgesehen sein. Indem multiple Instanzen von Matrix-Berechnungs-Blöcken verwendet werden, können mehr Berechnungen parallel ausgeführt werden (solange die erforderlichen Ressourcen auf dem programmierbaren Logikbaustein vorhanden sind). Die Größe der MatrixBerechnungs-Blöcke kann anhand der jeweiligen Eingangssignale gewählt werden, wobei der erste Matrix-Berechnungs-Block eine andere Größe als der zweite Matrix-Berechnungs-Block, wenn die Eingangssignale unterschiedliche Dimensionen aufweisen.

Vorzugsweise unterstützt ein Matrix-Berechnungs-Block verschiedene Matrixoperationen, wie die Addition zweier Matrizen, die Multiplikation einer Matrix mit einer Matrix oder die Multiplikation einer Matrix mit einem Vektor, wobei die aktive Matrixoperation anhand eines Steuersignals ausgewählt wird. In einer Ausführungsform kann es auch vorgesehen sein, eine vorgegebene mathematische Funktion auf jedes Element einer Eingangsmatrix anzuwenden. Beispielsweise kann die Berechnung des Kehrwerts 1/x oder einer trigonometrischen Funktion wie sin x, cos x, oder tan x erfolgen. Es ist vorteilhaft, wenn Art und Anzahl unterstützter Rechenoperationen bzw. - funktionen in dem Modell vorgegeben oder in Abhängigkeit eines Parameters gewählt werden. Insbesondere kann die bereitgestellte Funktionalität des MatrixBerechnungs-Blocks in Abhängigkeit von der freien Fläche bzw. den verfügbaren Logikelementen des verwendeten programmierbaren Logikbausteins gewählt werden.

Bevorzugt sind die Matrix-Routing-Blöcke dazu eingerichtet, Eingangssignale anzupassen, insbesondere umzubenennen oder Elemente in gewünschte Bereiche des Matrix-Berechnungs-Blocks zu verschieben, und ein Steuersignal zur Auswahl einer aktiven Matrixoperation an den Matrix-Berechnungs-Block auszugeben.

Die Erfindung betrifft ferner ein Computersystem umfassend einen Bedienrechner mit einer Mensch-Maschine-Schnittstelle und einen Arbeitsrechner, wobei der Arbeitsrechner einen Prozessor sowie einen programmierbaren Logikbaustein umfasst und dazu eingerichtet ist, ein erfindungsgemäßes Verfahren auszuführen.

Weiterhin betrifft die Erfindung ein computerlesbaren Speichermedium, auf dem Befehle eingebettet sind, die, wenn sie von einem Computersystem umfassend einen Prozessor und einen programmierbaren Logikbaustein ausgeführt werden, bewirken, dass dieses dazu eingerichtet ist, ein erfindungsgemäßes Verfahren auszuführen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die Abmessungen sind nicht maßstäblich und weisen, sofern nicht anders angegeben, auch keine ableitbaren geometrischen Relationen zueinander auf.

Darin zeigt:
- Figur 1: eine bevorzugte Ausführungsform eines Bedienrechners,
- Figur 2: eine bevorzugte Ausführungsform eines Echtzeitrechners,
- Figur 3: eine schematische Darstellung der Bestandteile eines Hybridfahrzeugs,
- Figur 4: eine schematische Darstellung einer Simulation eines Hybridfahrzeugs,
- Figur 5: eine schematische Darstellung eines grafischen Modells mit mehreren Matrixoperationen,
- Figur 6: eine Ausführungsform einer Matrixoperation mit Hilfe eines Matrix-Routing-Blocks und eines Matrix-Berechnungs-Blocks, und
- Figur 7: ein schematisches Diagramm der Auslastung eines MatrixBerechnungs-Blocks, der die Matrixoperationen von Figur 4 ausführt.

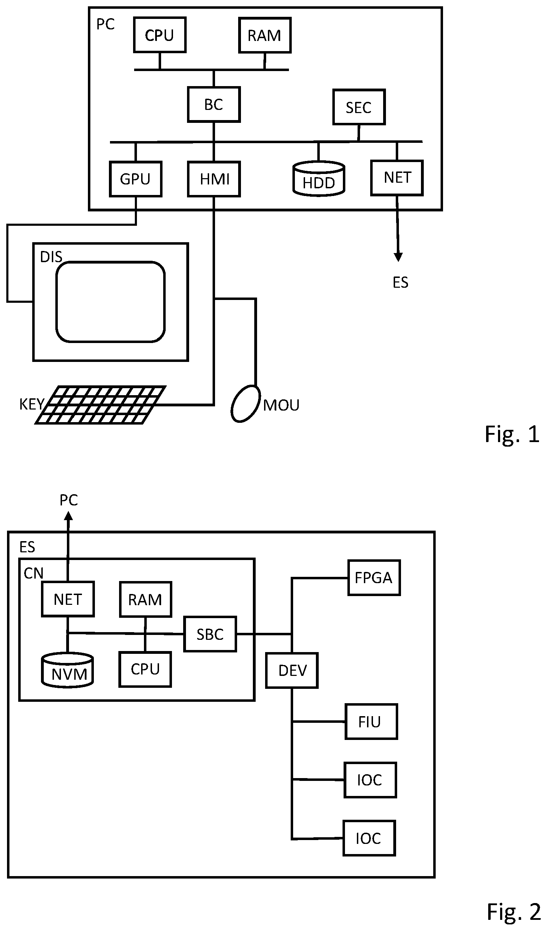

Figur 1 zeigt eine bevorzugte Ausführungsform eines Bedienrechners PC. Dieser weist einen Prozessor CPU, der insbesondere als Mehrkernprozessor realisiert sein kann, einen Arbeitsspeicher RAM und einen Buscontroller BC auf. Bevorzugt ist der Bedienrechner PC dazu ausgelegt, von einem Nutzer direkt manuell bedient zu werden, wobei über eine Grafikkarte GPU ein Monitor DIS und über eine Peripherieschnittstelle HMI eine Tastatur KEY und eine Maus MOU angeschlossen sind. Prinzipiell könnte der Bedienrechner PC auch ein Touch-Interface aufweisen. Der Bedienrechner umfasst weiterhin einen nichtflüchtigen Datenspeicher HDD, der insbesondere als Festplatte und/oder Solid State Disk ausgeführt sein kann, sowie eine Schnittstelle NET, insbesondere eine Netzwerkschnittstelle.

Über die Schnittstelle NET können weitere Rechner, wie insbesondere ein Echtzeitrechner ES angeschlossen werden. Prinzipiell können ein oder mehrere beliebige Schnittstellen, insbesondere drahtgebundene Schnittstellen, an dem Bedienrechner PC vorhanden und jeweils für die Verbindung mit weiteren Rechnern einsetzbar sein. Zweckmäßigerweise kann eine Netzwerkschnittstelle nach dem Ethernet-Standard verwendet werden, wobei zumindest die physikalische Schicht standardkonform ausgeführt ist; eine oder mehrere höhere Protokollschichten können auch proprietär bzw. an den Echtzeitrechner angepasst implementiert sein. Die Schnittstelle NET kann auch drahtlos ausgeführt sein, wie insbesondere als WLAN-Schnittstelle oder nach einem Standard wie Bluetooth. Hierbei kann es sich auch um eine Mobilfunkverbindung wie LTE handeln, wobei vorzugsweise die ausgetauschten Daten verschlüsselt sind. Es ist vorteilhaft, wenn zumindest eine Schnittstelle des Bedienrechners als Standard-Ethernet-Schnittstelle ausgeführt ist, so dass weitere Rechner einfach mit dem Bedienrechner PC verbunden werden können.

Der Bedienrechner PC kann einen gesicherten Datencontainer SEC aufweisen, was die Verwendung lizenzierter Anwendungen auf dem Bedienrechner erleichtert, aber auch die Verwendung des Bedienrechners als Lizenzserver für den Echtzeitrechner ermöglicht. Der gesicherte Datencontainer SEC kann beispielsweise in Form eines Dongles realisiert sein, der insbesondere mit einer Peripherieschnittstelle verbunden ist. Alternativ kann es auch vorgesehen sein, einen gesicherten Datencontainer SEC als Bauteil fest in dem Bedienrechner zu integrieren oder in Form einer Datei auf dem nichtflüchtigen Datenspeicher HDD zu hinterlegen.

In Figur 2 ist ein eine bevorzugte Ausführungsform eines Echtzeitrechners ES dargestellt. Dieser umfasst einen Rechenknoten CN, der über eine Netzwerkschnittstelle NET mit einem Bedienrechner PC verbunden ist. Prinzipiell muss die Verbindung nur während einer Anpassung der Konfiguration des Echtzeitrechners ES bestehen, vorzugsweise besteht sie dauerhaft. Der Rechenknoten CN weist mindestens einen Prozessor CPU, insbesondere einen Mehrkernprozessor, oder mehrere Prozessoren, einen Arbeitsspeicher RAM und einen nichtflüchtigen Speicher NVM auf, auf dem vorzugsweise ein Betriebssystem und/oder ein Bootloader hinterlegt sind. Über einen Hochgeschwindigkeitsbus SBC bzw. einen entsprechenden Controller sind mindestens ein Logikboard FPGA und eine Geräteschnittstelle DEV mit dem Rechenknoten verbunden. Das Logikboard FPGA umfasst einen programmierbaren Logikbaustein, der gemäß der vorliegenden Erfindung konfiguriert werden kann. Es kann auch vorgesehen sein, dass der Echtzeitrechner ES mehrere Logikboards FPGA bzw. mehrere programmierbare Logikbausteine auf einem Logikboard aufweist. Über die Geräteschnittstelle DEV können eine Vielzahl von Modulen angeschlossen werden, wie eine Fehlersimulationsschaltung FIU, die angeschlossene Geräte mit definierten elektrischen Fehlern beaufschlagt, oder Schnittstellenkarten IOC, die einen oder mehrere analoge oder digitale I/O-Kanäle bereitstellen.

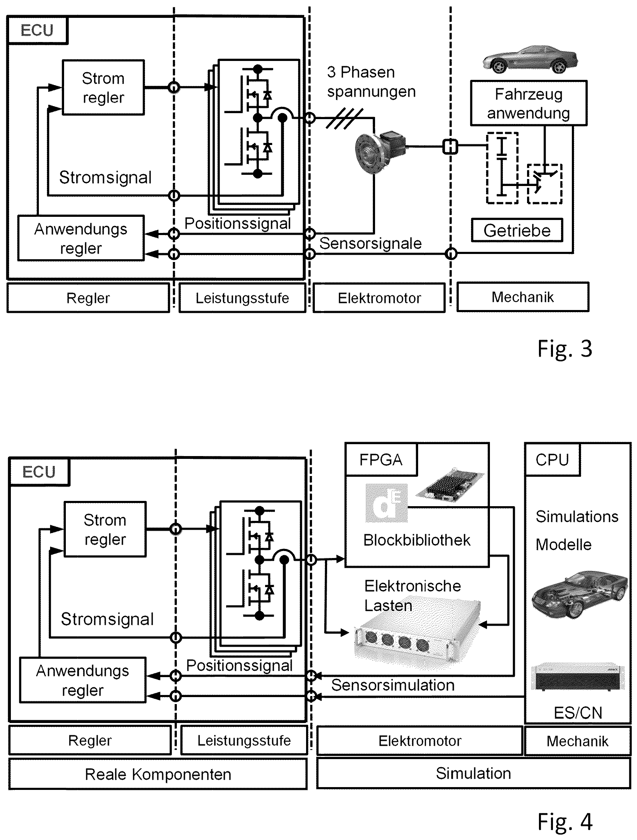

Figur 3 zeigt eine schematische Darstellung der Bestandteile eines Hybridfahrzeugs bzw. eines zumindest zeitweise von einem Elektromotor angetriebenen Kraftfahrzeugs.

Die Ansteuerung des Elektromotors erfolgt durch ein Steuergerät ECU, welches einen Regler und eine Leistungsstufe umfasst. Das Steuergerät ist mit einem Elektromotor verbunden und versorgt diesen beispielsweise mit 3 Phasenspannungen. Der Elektromotor kann auch eine größere Anzahl von Spulen aufweisen, die mit einer entsprechend größeren Anzahl von Phasenspannungen bzw. -strömen versorgt werden müssen. Der Elektromotor ist mechanisch mit einem Getriebe verbunden, über das insbesondere ein oder mehrere Fahrzeugräder angetrieben werden können. Elektromotoren werden aber auch in einer Reihe von anderen Fahrzeuganwendungen eingesetzt, die ebenfalls simuliert werden können. Das Fahrzeug weist eine Reihe von Sensoren, wie beispielsweise Raddrehzahlsensoren auf. Mindestens ein Ausgangssignal eines Sensors bzw. ein oder mehrere Sensorsignale werden Fahrzeugsteuergerät zugeführt. Auch der Elektromotor kann eine Reihe von Sensoren aufweisen, wie beispielsweise eine Positionssensor, der die Lage des Rotors relativ zum Stator angibt; dieses Positionssignal wird dem Steuergerät ebenfalls zugeführt.

Das Steuergerät umfasst einen Anwendungsregler, der die Sensorsignale des Fahrzeugs und das Positionssignal des Elektromotors empfängt und anhand eines Regelalgorithmus daraus Sollwerte für die an den einzelnen Phasen des Elektromotors ermittelt. Ein Stromregler steuert die Halbleiterschalter der Leistungsstufe bzw. des Inverters nach Maßgabe der Sollwerte an bzw. eines Vergleichs mit dem Stromsignal eines in der Leistungsstufe angeordneten Stromsensors, wie beispielsweise eines Shuntwiderstands.

Über drei gestrichelte Linien sind die verschiedenen Ebenen angedeutet, an denen eine Simulation des Elektromotors ansetzen kann. Auf der Signalebene, in welcher der Regler agiert, liegen nur elektrische Signale bzw. numerische Werte vor. Der Inverter agiert in der elektrischen Leistungsebene, in der beträchtliche elektrische Spannungen und Ströme bzw. elektrische Leistung auftreten können. Der Elektromotor setzt diese elektrische Leistung in mechanische Kräfte um. Wenn das Gesamtsystem aus Steuergerät und Motor auf mechanischer Ebene getestet werden soll, ist ein entsprechender Prüfstand erforderlich. Ein Test der Regelalgorithmen auf Signalebene könnte ggfs. auch in Form einer Softwaresimulation erfolgen.

In Figur 4 ist ein Schema einer Simulation eines Hybridfahrzeugs bzw. eines zumindest zeitweise von einem Elektromotor angetriebenen Kraftfahrzeugs dargestellt.

Das dargestellte Simulationssystem weist elektronische Lasten auf, welche die auf elektrischer Leistungsebene auftretenden Spannungen und Ströme verarbeiten bzw. manipulieren können. Somit wird ein Test eines als reale Komponente vorliegenden Steuergeräts möglich, ohne das bereits das gesamte Kraftfahrzeug vorhanden ist bzw. ohne dass die mit einem Fahrtest verbundenen Gefahren auftreten. Das Fahrzeug bzw. die mechanischen Komponenten werden basierend auf Simulationsmodellen auf einem Prozessor CPU des Rechenknotens CN bzw. des Echtzeitrechners ES simuliert. Die vom Steuergerät benötigten Sensorsignale werden mittels einer Sensorsimulation erzeugt, die von dem Prozessor und/oder einem programmierbaren Logikbaustein FPGA ausgeführt wird.

Um eine geringe Latenz sicherzustellen, werden die elektronischen Lasten von dem programmierbaren Logikbaustein FPGA angesteuert, dessen Konfiguration beispielsweise anhand einer Blockbibliothek erstellt wurde. Vorzugsweise umfasst die Blockbibliothek Matrix-Routing-Blöcke und Matrix-Berechnungs-Blöcke zur Durchführung eines erfindungsgemäßen Verfahrens.

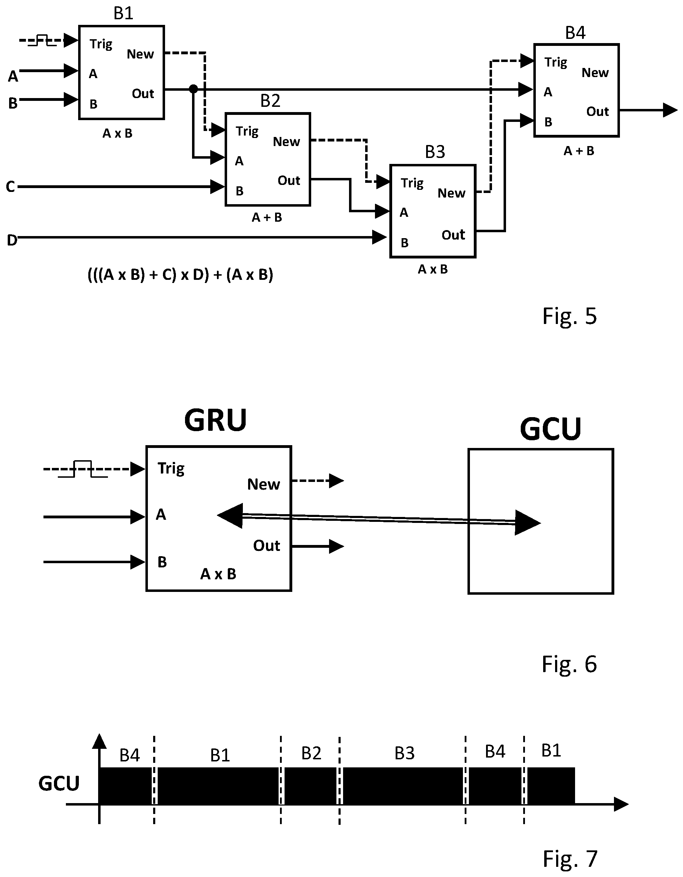

Figur 5 zeigt eine schematische Darstellung eines grafischen Modells mit mehreren Matrixoperationen.

Das gezeigte Modell umfasst vier Matrixoperations-Blöcke B1, B2, B3, B4, die untereinander über Signale verbunden sind. Jeder Matrixoperations-Block hat zwei Eingangssignale und gibt ein Ausgangssignal aus. Block B1 empfängt zwei Matrix-Signale A, B und berechnet das Produkt A x B. Block B2 empfängt das Ausgangssignal von B1 sowie ein weiteres Matrix-Signal C und berechnet die Summe (A x B) + C. Block B3 empfängt das Ausgangssignal von B2 sowie ein weiteres Matrix-Signal D und berechnet das Produkt (A x B) + C) x D. Block B4 empfängt die Ausgangssignale von B1 und B3 und gibt die Summe (((A x B) + C) x D) + (A x B) als Ausgangssignal aus.

Da die zeitliche Bearbeitung eine gewisse Verzögerung verursacht und eine nachgelagerte Berechnung auf das Ergebnis der vorgelagerten Berechnungsstufe warten muss, werden nachfolgende Operationen zweckmäßigerweise durch einen externen Puls angestoßen. Die Matrixoperations-Blöcke haben zu diesem Zweck einen Trigger-Eingang Trig. Wenn die Berechnung erfolgt ist, wird der Trigger-Impuls zum Aktivieren der Berechnung über den Trigger-Ausgang New an die nächste Komponente weitergegeben.

Werden die Matrixoperations-Blöcke wie bisher üblich als monolithische Blöcke implementiert, resultiert das in eine schlechte Ausnutzung der HW, da eine Matrix-Berechnung nur für eine kurze Zeit aktiv ist ("Work-time") und nach erfolgter Berechnung auf den nächsten Impuls wartet ("Idle-time"). Der nächste Trigger-Impuls wird jedoch erst dann empfangen, wenn die komplette Kette aus Matrixoperations-Blöcken durchlaufen wurde. Dieses führt zu einer geringen Ausnutzung einer implementierten Matrix-Berechnung bzw. einem schlechten Work-Idle-Verhältnis. Die Matrixoperations-Blöcke nehmen eine große Fläche auf dem programmierbaren Logikbaustein ein.

Figur 6 zeigt eine Ausführungsform einer Matrixoperation mit Hilfe eines Matrix-Routing-Blocks und eines Matrix-Berechnungs-Blocks gemäß der Erfindung.

Anstelle eines monolithischen Matrixoperations-Blocks werden ein Matrix-Routing-Block GRU und ein Matrix-Berechnungs-Block GCU verwendet. Der Matrix-Routing-Block GRU empfängt die Eingangssignale A, B und gibt das Ausgangssignal Out aus. Weiterhin hat der Matrix-Routing-Block GRU einen Trigger-Eingang Trig und einen Trigger-Ausgang New. Der Matrix-Routing-Block GRU bietet eine "Gateway/Routing"-Funktionalität und gibt die jeweiligen Daten an einen verknüpften Matrix-Berechnungs-Block GCU weiter, der die jeweilige Berechnung durchführt. Nach erfolgter Berechnung wird das Ergebnis wiederum im Matrix-Routing-Block GRU gespeichert, der auch das Trigger-Signal weitergibt.

Mehrere Matrix-Routing-Blöcke können mit einem einzigen Matrix-Berechnungs-Block GCU verbunden sein. Da die nachgelagerte Berechnung mit dem gleichen Matrix-Berechnungs-Block GCU durchgeführt wird, lässt sich eine weitaus bessere Ausnutzung der Logikelemente auf dem programmierbaren Logikbaustein realisieren. Nur der Berechnungs-Block GCU benötigt dedizierte Hardwareressourcen für Berechnungen und kann darüber hinaus neben verschiedenen Grundrechenarten auch komplexere auf Matrizen anwendbare Berechnungen unterstützen. Zweckmäßigerweise wählt ein Matrix-Routing-Block GRU über ein Konfigurationssignal bzw. Konfigurationswort die aktuelle Rechenoperation des Matrix-Berechnungs-Blocks aus, der somit bedarfsgerecht gesteuert werden kann.

Figur 7 zeigt ein schematisches Diagramm der Auslastung eines MatrixBerechnungs-Blocks GCU, der die Matrixoperationen von Figur 4 ausführt.

Hierbei ist angegeben welche der nummerierten Matrixoperationen bzw. Blöcke B1, B2, B3, B4 gerade von dem Matrix-Berechnungs-Block GCU ausgeführt werden. Der Matrix-Berechnungs-Block ist zu einem hohen Grad ausgelastet, lediglich an den mit gestrichelten Linien angedeuteten Übergängen zwischen verschiedenen Matrixoperationen kann es zu einer kurzen Verzögerung kommen.

Falls mehr Rechenleistung notwendig ist kann der Matrixberechnungs-Block GCU vervielfältigt bzw. mehrere GCU-Blöcke eingesetzt werden, welche mit einem Teil der Matrix-Routing-Blöcke GRU verbunden sind und so eine parallele Bearbeitung realisieren.

In einer Ausführungsform der Erfindung können die Matrix-Routing-Blöcke und die Matrix-Berechnungs-Blöcke in einer Blockbibliothek für eine technische Rechenumgebung wie MATLAB/Simulink implementiert sein. Es ist vorteilhaft, wenn die Matrix-Routing-Blöcke eine Bedienoberfläche aufweisen, in der ein Matrix-Berechnungs-Block ausgewählt werden kann, dem die Eingangssignale zur Berechnung zugeführt werden. In der Bedienoberfläche kann auch eine Wahl der gewünschten Rechenoperation, wie eine Matrixmultiplikation, -addition, oder das elementweise Anwenden einer vorgegebenen Funktion auf die Elemente einer Eingangsmatrix ausgewählt werden. Matrix-Berechnungs-Blöcke können als generische Berechnungsblöcke ausgestaltet sein, die einen vorgegebenen Berechnungsumfang unterstützen, wobei die verbundenen Matrix-Routing-Blöcke über ein Signal oder ein Kommando die gewünschte Berechnung aus dem vorgegebenen Umfang auswählen. Es kann auch vorgesehen sein, dass MatrixBerechnungs-Blöcke eine Bedienoberfläche aufweisen, in denen ein Maß der Parallelisierung der Berechnungen gewählt werden kann. Insbesondere kann eine parallele Bearbeitung einer ganzen Zeile der Matrix oder eine Aufteilung in parallel bearbeitete Blöcke erfolgen, was von einem Benutzer beispielsweise über einen Slider eingestellt werden kann. Die Blockbibliothek kann MatrixBerechnungs-Blöcke in verschiedenen Größen umfassen, so dass einfach ein passender Block gewählt werden kann. Eine Zuordnung zwischen Matrix-Routing-Blöcken und Matrix-Berechnungs-Blöcken kann anhand von einer Berechnungsnummer und/oder Blockbezeichnern bzw. -namen erfolgen. Aus einem erstellten Modell kann beispielsweise mittels des Xilinx System Generator ein Bitstrom für einen programmierbaren Logikbaustein erzeugt werden.

Durch das erläuterte Verfahren der Berechnung ergeben sich folgende Vorteile:
- Anhand der Signalwege zwischen den Matrix-Routing-Blöcken kann die Abfolge der Matrixoperationen leicht verstanden werden, das Modell bleibt lesbar
- Das Routing von Matrix-Routing-Blöcken GRU zu verschiedenen MatrixBerechnungs-Blöcken GCU wird für den Nutzer transparent realisiert
- Dedizierte Hardwareressourcen zur Berechnung wie DSP-Slices werden besser ausgenutzt.

Dadurch, dass weniger Berechnungs-Blöcke verwendet werden, können pro Block mehr dedizierten Hardwareressourcen zur Berechnung eingesetzt werden, was weitere Vorteile ermöglicht:
- Matrixberechnungen können weitestgehend parallel aufgebaut werden, wodurch die Latenz minimiert wird.
- Matrixberechnungen können in einer höheren Bitbreite (z.B. Double Precision anstelle von Single) realisiert werden, wodurch eine genauere Simulation ermöglicht wird.

## Patentansprüche

1. Verfahren zur Echtzeitsimulation einer elektrischen Schaltung, wobei die elektrische Schaltung in einem grafischen Modell umfassend mindestens zwei durch Signale verbundene Blöcke modelliert ist, wobei das grafische Modell mindestens zwei Matrixoperationen (B1, B2, B3, B4) umfasst, welche ein mehrdimensionales Ausgangssignal aus mindestens einem mehrdimensionalen Eingangssignal erzeugen, wobei das Verfahren auf einem Rechnersystem aus einem Bedienrechner (PC) und einem mit diesem verbundenen Echtzeitrechner (ES) ausgeführt wird, wobei der Bedienrechner (PC) eine grafische Modellierungsumgebung ausführt und der Echtzeitrechner (ES) mindestens einen programmierbaren Logikbaustein (FPGA) aufweist, wobei Matrixoperationen (B1, B2, B3, B4) in zwei getrennten Blöcken implementiert sind, einem Matrix-Routing-Block (GRU) und einem MatrixBerechnungs-Block (GCU), wobei Matrix-Routing-Blöcke und MatrixBerechnungs-Blöcke in einer Blockbibliothek für eine technische Rechenumgebung implementiert sind, wobei der Matrix-Berechnungs-Block (GCU) dazu eingerichtet ist, auf ein aktuell empfangenes Eingangssignal eine Operation anzuwenden, um ein Ausgangssignal zu berechnen, und wobei zumindest aus einem die Matrixoperationen (B1, B2, B3, B4) umfassenden Teil des grafischen Modells ein Bitstrom generiert und auf dem programmierbaren Logikbaustein (FPGA) ausgeführt wird, wobei der Matrix-Routing-Block (GRU) dazu eingerichtet ist, den Matrix-Berechnungsblock (GCU) mit dem jeweils mindestens einen Eingangssignal zu versorgen und das berechnete Ausgangssignal zu speichern, wobei die erste Matrixoperation (B1) und die zweite Matrixoperation (B3) zwei getrennte Matrix-Routing-Blöcke (GRU), aber einen gemeinsamen MatrixBerechnungs-Block (GCU) umfassen, wobei die Berechnung mit dem gemeinsamen Matrix-Berechnungs-Block GCU durchgeführt wird, wobei nur der MatrixBerechnungs-Block dedizierte Hardwareressourcen für Berechnungen benötigt, wobei der Matrix-Routing-Block (GRU) der ersten Matrixoperation (B1) und der Matrix-Routing-Block (GRU) der zweiten Matrixoperation (B2) abwechselnd dem Matrix-Berechnungs-Block (GCU) Eingangssignale zuführen und Ausgangssignale empfangen.

2. Verfahren nach Anspruch 1, wobei der Matrix-Berechnungs-Block (GCU) dazu eingerichtet ist, auf die Elemente mindestens eines Eingangssignals zeilenweise parallel eine Operation anzuwenden.

3. Verfahren nach Anspruch 1 oder 2, wobei der Matrix-Berechnungs-Block (GCU) zur Verarbeitung von quadratischen Matrizen eingerichtet ist, wobei die Größe der quadratischen Matrix so gewählt ist, dass diese sowohl die Eingangssignale der ersten Matrixoperation (B1) als auch die Eingangssignale der zweiten Matrixoperation (B2) umfassen kann, insbesondere anhand der jeweils größten Dimension eines Eingangssignals gewählt wird, und wobei die Berechnung der quadratischen Matrix gestoppt wird, sobald alle Elemente des Ausgangssignals der aktuell aktiven Matrixoperation (B1, B2, B3, B4) berechnet wurden.

4. Verfahren nach einem der vorhergehenden Ansprüche, wobei der MatrixBerechnungs-Block (GCU) das aus der Anwendung einer Operation auf ein Eingangssignal resultierende Ausgangsignal nicht zwischenspeichert.

5. Verfahren nach einem der vorhergehenden Ansprüche, wobei der Matrix-Routing-Block (GRU) der ersten Matrixoperation (B1) und der Matrix-Routing-Block (GRU) der zweiten Matrixoperation (B2) ein Trigger-Signal empfangen und weitergeben, um den aktiven Matrix-Routing-Block (GRU) zu bestimmen, wohingegen der Matrix-Berechnungs-Block (GCU) immer aktiv ist.

6. Verfahren nach Anspruch 5, wobei ein Matrix-Routing-Block (GRU) auf das Empfangen des Trigger-Signals dem verbundenen Matrix-Berechnungs-Block (GRU) das mindestens eine Eingangssignal zuführt und auf das Abspeichern des resultierenden Ausgangssignals das Trigger-Signal weitergibt.

7. Verfahren nach einem der vorhergehenden Ansprüche, wobei mehr als zwei Matrix-Routing-Blöcke (GRU) mit einem Matrix-Berechnungs-Block (GCU) verbunden werden können, und wobei der Matrix-Berechnungs-Block (GCU) dazu eingerichtet ist, fortlaufend die Matrixoperationen (B1, B2, B3, B4) aller verbundenen Matrix-Routing-Blöcke (GRU) auszuführen, so dass in jedem Zeitschritt der Simulation alle zu einem verbundenen Matrix-Routing-Block (GRU) gehörenden Matrixoperationen (B1, B2, B3, B4) einmal durchgeführt werden.

8. Verfahren nach einem der vorhergehenden Ansprüche, wobei das grafische Modell mehr als einen Matrix-Berechnungs-Block (GCU) umfasst, wobei mindestens zwei erste Matrix-Routing-Blöcke (GRU) mit dem ersten MatrixBerechnungs-Block (GCU) verbunden sind und mindestens zwei zweite Matrix-Routing-Blöcke (GRU) mit dem zweiten Matrix-Berechnungs-Block (GCU) verbunden sind.

9. Verfahren nach einem der vorhergehenden Ansprüche, wobei die Elemente mindestens eines mehrdimensionalen Eingangssignals und/oder die Elemente mindestens eines mehrdimensionalen Ausgangssignals als Datentyp eine Fließkommazahl aufweisen, insbesondere Double.

10. Verfahren nach einem der vorhergehenden Ansprüche, wobei ein MatrixBerechnungs-Block (GCU) verschiedene Matrixoperationen (B1, B2, B3, B4), wie die Addition zweier Matrizen, die Multiplikation einer Matrix mit einer Matrix oder die Multiplikation einer Matrix mit einem Vektor unterstützt, und wobei die aktive Matrixoperation (B1, B2, B3, B4) anhand eines Steuersignals ausgewählt wird.

11. Verfahren nach einem der vorhergehenden Ansprüche, wobei die Matrix-Routing-Blöcke (GRU) dazu eingerichtet sind, Eingangssignale anzupassen, insbesondere umzubenennen oder Elemente in gewünschte Bereiche des Matrix-Berechnungs-Blocks (GCU) zu verschieben, und ein Steuersignal zur Auswahl einer aktiven Matrixoperation (B1, B2, B3, B4) an den MatrixBerechnungs-Block (GCU) auszugeben.

12. Computersystem umfassend einen Bedienrechner (PC) mit einer Mensch-Maschine-Schnittstelle und einen Echtzeitrechner (ES), wobei der Echtzeitrechner (ES) einen Prozessor (CPU) sowie einen programmierbaren Logikbaustein (FPGA) umfasst, wobei das Computersystem dazu eingerichtet ist, ein Verfahren gemäß einem der vorhergehenden Ansprüche auszuführen.

13. Computerlesbaren Speichermedium, auf dem Befehle eingebettet sind, die, wenn sie von einem Computersystem umfassend einen Prozessor (CPU) und einen programmierbaren Logikbaustein (FPGA) ausgeführt werden, bewirken, dass dieses dazu eingerichtet ist, ein Verfahren gemäß einem der vorhergehenden Ansprüche auszuführen.

## Claims

1. Method for real-time simulation of an electrical circuit, the electrical circuit being modeled in a graphical model comprising at least two blocks connected by signals, the graphical model comprising at least two matrix operations (B1, B2, B3, B4) which generate a multidimensional output signal from at least one multidimensional input signal, the method being executed on a computer system comprising an operating computer (PC) and a real-time computer (ES) connected thereto, wherein the operating computer (PC) executes a graphical modeling environment and the real-time computer (ES) comprises at least one programmable logic device (FPGA), wherein matrix operations (B1, B2, B3, B4) are implemented in two separate blocks, a matrix routing block (GRU) and a matrix computation block (GCU), wherein matrix routing blocks and matrix computation blocks are implemented in a block library for a technical computing environment, wherein the matrix calculation block (GCU) is arranged to apply an operation to a currently received input signal to calculate an output signal, and wherein a bit stream is generated from at least a part of the graphical model comprising the matrix operations (B1, B2, B3, B4) and executed on the programmable logic device (FPGA), wherein the matrix routing block (GRU) is arranged to supply the matrix calculation block (GCU) with the respective at least one input signal and to store the calculated output signal, wherein the first matrix operation (B1) and the second matrix operation (B3) comprise two separate matrix routing blocks (GRU) but a common matrix calculation block (GCU), wherein the calculation is performed with the common matrix calculation block (GCU), wherein only the matrix calculation block requires dedicated hardware resources for calculations, wherein the matrix routing block (GRU) of the first matrix operation (B1) and the matrix routing block (GRU) of the second matrix operation (B2) alternately supply input signals to and receive output signals from the matrix calculation block (GCU).

2. Method according to claim 1, wherein the matrix calculation block (GCU) is arranged to apply an operation to the elements of at least one input signal line by line in parallel.

3. Method according to claim 1 or 2, wherein the matrix calculation block (GCU) is set up to process square matrices, wherein the size of the square matrix is selected such that it can comprise both the input signals of the first matrix operation (B1) and the input signals of the second matrix operation (B2), in particular is selected on the basis of the respective largest dimension of an input signal, and wherein the calculation of the square matrix is stopped as soon as all elements of the output signal of the currently active matrix operation (B1, B2, B3, B4) have been calculated.

4. Method according to any of the preceding claims, wherein the matrix calculation block (GCU) does not buffer the output signal resulting from the application of an operation to an input signal.

5. Method according to any of the preceding claims, wherein the matrix routing block (GRU) of the first matrix operation (B1) and the matrix routing block (GRU) of the second matrix operation (B2) receive and pass a trigger signal to determine the active matrix routing block (GRU), whereas the matrix calculation block (GCU) is always active.

6. Method according to claim 5, wherein a matrix routing block (GRU) supplies the at least one input signal to the connected matrix calculation block (GRU) upon receiving the trigger signal and transmits the trigger signal upon storing the resulting output signal.

7. Method according to any of the preceding claims, wherein more than two matrix routing blocks (GRU) can be connected to a matrix calculation block (GCU), and wherein the matrix calculation block (GCU) is arranged to continuously perform the matrix operations (B1, B2, B3, B4) of all connected matrix routing blocks (GRU), so that all matrix operations (B1, B2, B3, B4) belonging to a connected matrix routing block (GRU) are performed once in each time step of the simulation.

8. Method according to any of the preceding claims, wherein the graphical model comprises more than one matrix computation block (GCU), wherein at least two first matrix routing blocks (GRU) are connected to the first matrix computation block (GCU) and at least two second matrix routing blocks (GRU) are connected to the second matrix computation block (GCU).

9. Method according to any of the preceding claims, wherein the elements of at least one multidimensional input signal and/or the elements of at least one multidimensional output signal have a floating point data type, in particular double.

10. Method according to any of the preceding claims, wherein a matrix calculation block (GCU) supports various matrix operations (B1, B2, B3, B4), such as the addition of two matrices, the multiplication of a matrix by a matrix or the multiplication of a matrix by a vector, and wherein the active matrix operation (B1, B2, B3, B4) is selected on the basis of a control signal.

11. Method according to any of the preceding claims, wherein the matrix routing blocks (GRU) are arranged to adapt input signals, in particular to rename or move elements to desired areas of the matrix calculation block (GCU), and to output a control signal for selecting an active matrix operation (B1, B2, B3, B4) to the matrix calculation block (GCU).

12. Computer system comprising an operating computer (PC) with a man-machine interface and a real-time computer (ES), wherein the real-time computer (ES) comprises a processor (CPU) and a programmable logic device (FPGA), wherein the computer system is adapted to execute a method according to any of the preceding claims.

13. Computer readable storage medium on which are embedded instructions which, when executed by a computer system comprising a processor (CPU) and a programmable logic device (FPGA), cause it to be adapted to execute a method according to any of the preceding claims.

## Revendications

1. Procédé de simulation en temps réel d'un circuit électrique, le circuit électrique étant modélisé dans un modèle graphique comprenant au moins deux blocs reliés par des signaux, le modèle graphique comprenant au moins deux opérations matricielles (B1, B2, B3, B4) qui génèrent un signal de sortie multidimensionnel à partir d'au moins un signal d'entrée multidimensionnel, le procédé étant exécuté sur un système informatique composé d'un ordinateur de commande (PC) et d'un ordinateur en temps réel (ES) relié à celui-ci, dans lequel l'ordinateur de commande (PC) exécute un environnement de modélisation graphique et l'ordinateur en temps réel (ES) comprend au moins un module logique programmable (FPGA), dans lequel des opérations matricielles (B1, B2, B3, B4) sont mises en oeuvre dans deux blocs séparés, un bloc de routage matriciel (GRU) et un bloc de calcul matriciel (GCU), dans lequel les blocs de routage matriciel et les blocs de calcul matriciel sont mis en oeuvre dans une bibliothèque de blocs pour un environnement de calcul technique, dans lequel le bloc de calcul de matrice (GCU) est conçu pour appliquer une opération à un signal d'entrée actuellement reçu afin de calculer un signal de sortie, et dans lequel un flux de bits est généré au moins à partir d'une partie du modèle graphique comprenant les opérations de matrice (B1, B2, B3, B4) et est exécuté sur le module logique programmable (FPGA), le bloc de routage de matrice (GRU) étant conçu à alimenter le bloc de calcul matriciel (GCU) avec le au moins un signal d'entrée respectif et à stocker le signal de sortie calculé, la première opération matricielle (B1) et la deuxième opération matricielle (B3) comprenant deux blocs de routage matriciel (GRU) séparés, mais un bloc de calcul matriciel commun (GCU), le calcul étant effectué avec le bloc de calcul matriciel commun GCU, seul le bloc de calcul matriciel nécessitant des ressources matérielles dédiées pour les calculs, dans lequel le bloc de routage matriciel (GRU) de la première opération matricielle (B1) et le bloc de routage matriciel (GRU) de la deuxième opération matricielle (B2) fournissent alternativement des signaux d'entrée au bloc de calcul matriciel (GCU) et reçoivent des signaux de sortie.

2. Procédé selon la revendication 1, dans lequel le bloc de calcul matriciel (GCU) est agencé pour appliquer une opération en parallèle, ligne par ligne, aux éléments d'au moins un signal d'entrée.

3. Procédé selon la revendication 1 ou 2, dans lequel le bloc de calcul de matrice (GCU) est agencé pour traiter des matrices carrées, la taille de la matrice carrée étant choisie de telle sorte qu'elle puisse comprendre aussi bien les signaux d'entrée de la première opération de matrice (B1) que les signaux d'entrée de la deuxième opération de matrice (B2), en particulier étant choisie à l'aide de la plus grande dimension respective d'un signal d'entrée, et le calcul de la matrice carrée étant arrêté dès que tous les éléments du signal de sortie de l'opération de matrice actuellement active (B1, B2, B3, B4) ont été calculés.

4. Procédé selon l'une quelconque des revendications précédentes, dans lequel le bloc de calcul matriciel (GCU) ne met pas en mémoire tampon le signal de sortie résultant de l'application d'une opération à un signal d'entrée.

5. Procédé selon l'une quelconque des revendications précédentes, dans lequel le bloc de routage matriciel (GRU) de la première opération matricielle (B1) et le bloc de routage matriciel (GRU) de la deuxième opération matricielle (B2) reçoivent et transmettent un signal de déclenchement pour déterminer le bloc de routage matriciel (GRU) actif, tandis que le bloc de calcul matriciel (GCU) est toujours actif.

6. Procédé selon la revendication 5, dans lequel un bloc de routage matriciel (GRU), lors de la réception du signal de déclenchement, fournit au moins un signal d'entrée au bloc de calcul matriciel (GRU) connecté et, lors de la mémorisation du signal de sortie résultant, transmet le signal de déclenchement.

7. Procédé selon l'une quelconque des revendications précédentes, dans lequel plus de deux blocs de routage matriciel (GRU) peuvent être connectés à un bloc de calcul matriciel (GCU), et dans lequel le bloc de calcul matriciel (GCU) est agencé pour exécuter en continu les opérations matricielles (B1, B2, B3, B4) de tous les blocs de routage matriciel (GRU) connectés, de sorte qu'à chaque étape temporelle de la simulation, toutes les opérations matricielles (B1, B2, B3, B4) appartenant à un bloc de routage matriciel (GRU) connecté sont exécutées une fois.

8. Procédé selon l'une quelconque des revendications précédentes, dans lequel le modèle graphique comprend plus d'un bloc de calcul matriciel (GCU), dans lequel au moins deux premiers blocs de routage matriciel (GRU) sont connectés au premier bloc de calcul matriciel (GCU) et au moins deux seconds blocs de routage matriciel (GRU) sont connectés au second bloc de calcul matriciel (GCU).

9. Procédé selon l'une quelconque des revendications précédentes, dans lequel les éléments d'au moins un signal d'entrée multidimensionnel et/ou les éléments d'au moins un signal de sortie multidimensionnel présentent comme type de données un nombre à virgule flottante, en particulier Double.

10. Procédé selon l'une des revendications précédentes, dans lequel un bloc de calcul matriciel (GCU) supporte différentes opérations matricielles (B1, B2, B3, B4), telles que l'addition de deux matrices, la multiplication d'une matrice par une matrice ou la multiplication d'une matrice par un vecteur, et dans lequel l'opération matricielle active (B1, B2, B3, B4) est sélectionnée à l'aide d'un signal de commande.

11. Procédé selon l'une quelconque des revendications précédentes, dans lequel les blocs de routage matriciel (GRU) sont agencés pour adapter des signaux d'entrée, en particulier pour renommer ou déplacer des éléments dans des zones souhaitées du bloc de calcul matriciel (GCU), et pour émettre un signal de commande pour sélectionner une opération matricielle active (B1, B2, B3, B4) vers le bloc de calcul matriciel (GCU).

12. Système informatique comprenant un ordinateur de commande (PC) avec une interface homme-machine et un ordinateur en temps réel (ES), l'ordinateur en temps réel (ES) comprenant un processeur (CPU) ainsi qu'un module logique programmable (FPGA), le système informatique étant agencé pour mettre en œuvre un procédé selon l'une quelconque des revendications précédentes.

13. Un support de stockage lisible par ordinateur sur lequel sont intégrées des instructions qui, lorsqu'elles sont exécutées par un système informatique comprenant un processeur (CPU) et un composant logique programmable (FPGA), le rendent apte à mettre en œuvre un procédé selon l'une quelconque des revendications précédentes.
